# EUROPÄISCHE PATENTSCHRIFT

(11) **EP 0 468 208 B1**
(45) Veröffentlichungstag und Bekanntmachung des Hinweises auf die Patenterteilung: **17.08.1994**
(21) Anmeldenummer: 91110357.0
(22) Anmeldetag: 24.06.1991
(51) Int. Cl.: C25D 21/04

(54) **Vorrichtung zum Galvanisieren von Behandlungsgut in einer Reihe von hintereinander angeordneten Bädern**
Apparatus for the electrolytic treatment of workpieces through a succession of baths
Dispositif pour le traitement électrolytique d'objets à travers une série de bains

(30) Priorität: 27.07.1990 DE 4023865
(43) Veröffentlichungstag der Anmeldung: 29.01.1992
(73) Patentinhaber: ATOTECH Deutschland GmbH, 10553 Berlin (DE)
(72) Erfinder: Kosikowski, Thomas, W-8501 Burgthann (DE)
(74) Vertreter: Effert, Udo, Dipl.-Ing.

(56) Entgegenhaltungen:
- US-A- 4 772 374

## Beschreibung

Die Erfindung betrifft eine Vorrichtung zum Galvanisieren von Behandlungsgut (z.B. von elektronischen Leiterplatten) gemäß dem Oberbegriff des Anspruches 1. Eine solche Vorrichtung ist im wesentlichen Gegenstand der älteren nicht vorveröffentlichten DE-A- 3908778 der Anmelderin, auf deren Offenbarungsinhalt Bezug genommen wird, soweit er nicht bereits nachstehend angeführt und zeichnerisch dargestellt ist. Die Absaugung gemäß der vorgenannten DE-A- 3908778 hat sich bewährt. In den Badbehältern befinden sich die Badflüssigkeit der jeweiligen Bäder.

Aus DE-OS 26 08 550 ist eine Anordnung bekannt, bei der sich ein Dachelement in einem Abstand oberhalb der oberen Stirnseite des Badbehälters befindet und nicht auf diese Oberseite abgesenkt werden kann. Ein trommelartiger Warenträger ist über eine Führungsstange relativ zu der vorgenannten Abdeckung in den Badbehälter absenkbar und aus diesem wieder abhebbar. Weder der Oberbegriff des Anspruches 1 noch die Lehre des Kennzeichens des Anspruches 1 sind dieser Literaturstelle zu entnehmen. Das gleiche gilt für den Inhalt von US-PS 4 772 374, bei der ein Deckel mit einem Werkstückträger fest verbunden ist, wobei durch Absenken des Werkstückträgers der Deckel die Öffnung der jeweiligen Behandlungsstation verschließt. Aus DE-OS 35 30 322 sind abhebbare Deckel bekannt, wobei aber die Greifvorrichtungen zum Abheben und Aufbringen des Deckels gesonderte Bauteile sind und nicht von Warenträgern gebildet werden.

Die Aufgabenstellung der Erfindung besteht demgegenüber darin, eine Vorrichtung gemäß dem Oberbegriff des Anspruches 1 derart auszugestalten, daß die Bewegung des jeweiligen Deckels in die und aus der Schließlage vereinfacht und außerdem mit einfachen Mitteln ein Hin- und Herbewegen des Gutes im Bad erreicht wird.

Die Lösung dieser Aufgabe wird, ausgehend vom Oberbegriff des Anspruches 1, in den Merkmalen des Kennzeichens des Anspruches 1 gesehen. Während beim Gegenstand von DE-A- 3908778 am Transportwagen eine Anordnung zum Abheben und Bewegen des Deckels zur Seite bzw. wieder zurück in eine Lage oberhalb des Bades und zum Absenken vorgesehen wurde, ist demgegenüber die Vorrichtung nach der Erfindung wesentlich einfacher. Die Warenträger müssen sowieso vom Transportwagen mit dem Gut über das Bad eingebracht, zur Behandlung des Gutes in dem Bad abgesenkt, dann wieder herausgenommen und schließlich vom Transportwagen weiterbewegt werden. Die erfindungsgemäß mit dem Warenträger lösbar verbundenen und von diesem getragenen Deckel werden somit zugleich mit der vorstehend geschilderten Bewegung des Warenträgers in die Abdecklage gebracht, sowie nach erfolgter Behandlung des Gutes im Bad vom Warenträger wieder abgehoben, zum nächsten Bad gebracht und so weiter. Der Aufwand einer gesonderten Anordnung für das Bewegen und Absenken des Deckels entfällt. Hiermit wird nicht nur an Herstellungskosten, sondern auch an Bearbeitungszeit gespart, da eine solche Anordnung beim Gegenstand von DE-A- 3908778 nicht zugleich mit dem Bewegen des Warenträgers wirksam werden konnte, sondern nur vor dem Absenken des Warenträgers, sowie vor und nach dem Ausheben des Warenträgers. Dies erforderte einen entsprechenden Mehraufwand an Zeit. Die Lösbarkeit des Warenträgers vom Deckel nach dessen Auflage auf dem Badbehälter oder der Absaugung sowie das Bewegen des Warenträgers weiter nach unten in die im Kennzeichen des Anspruches 1 angegebene Position erlaubt, daß der Warenträger zwecks Bewegung des Gutes im Bad in horizontaler Richtung hin- und herbewegt werden kann. In dieser abgesenkten Stellung liegt der Warenträger auf Einweisungen der betreffenden Station bzw. des betreffenden Badbehälters auf. Da während dieses Hin- und Herbewegens des Warenträgers dieser vom Deckel gelöst ist, bleibt der Deckel dabei unbewegt in seiner Schließlage. Nach Beendigung der Hin- und Herbewegung des Warenträgers wird dieser angehoben und nimmt dabei den Deckel mit. Die vorgenannten Vorteile werden mit gegenüber dem Stand der Technik konstruktiv sehr einfachen Mitteln erreicht.

Die Merkmale des Anspruches 2 ermöglichen bei einem Gut, bestehend aus mit Bohrungen versehenen Platten, z.B. Leiterplatten, daß die Badflüssigkeit in Längsrichtung der Bohrungen durch diese hindurch strömt.

Die Merkmale der Ansprüche 3 bis 5 beinhalten vorteilhafte lösbare Halterungen zwischen Warenträger und Deckel.

Bei den Badbehältern, in denen die eigentliche Behandlung unter Anwendung eines bestimmten Verfahrens abläuft, handelt es sich entweder um Badbehälter, die nur für die Aufnahme eines Warenträgers mit daran hängendem Gut ausgebildet sind und eine entsprechende Badflüssigkeit aufweisen. Man kann aber auch in einem Badbehälter mehrere sogenannte Zellen vorsehen, wobei in jede Zelle ein Warenträger mit Gut einbringbar ist. Dabei können die Zellen eines Badbehälters sich in derselben Badflüssigkeit befinden, oder aber die Zellen eines Badbehälters sind voneinander durch Trennwände unterteilt. Im letztgenannten Fall kann jede Zelle ihre eigene Badflüssigkeit haben. Der sprachlichen Einfachheit wegen ist in den Ansprüchen und teilweise auch in der übrigen Beschreibung nur von "Badbehältern" die Rede, womit aber auch die vorgenannten Ausführungsmöglichkeiten eingeschlossen sind.

Während des Betriebes von mehreren hintereinander angeordneten und an ihrer Oberseite offenen, eine Badflüssigkeit aufnehmenden Badbehältern kann wiederholt und an mehreren Badbehältern, bzw. deren Zellen die Situation eintreten, daß in ihnen zwar kein Gut behandelt wird, andererseits aber die in ihnen befindliche Badflüssigkeit abzudecken ist. Hierzu dienen Leerträger gemäß den Merkmalen des Anspruches 6.

Bevorzugt ist bei einer Vorrichtung nach der Erfindung in der Abdecklage des Deckels zwischen ihm und dem Badbehälter oder Absaugungen ein Luftdurchtritt vorgesehen (Anspruch 7), wie er an sich schon, bevorzugt in Schlitzform beim Gegenstand von DE-A- 3908778 vorhanden ist. Im Falle einer ausreichenden Luftzufuhr vom Bereich der beiden Stirnseiten des Badbehälters her in das Badbehälterinnere kann aber auf einen solchen Luftdurchtritt zwischen Deckel und Absaugungen oder Badbehälter verzichtet werden, da in diesen Fällen in der Regel von den Stirnseiten des Badbehälters her noch so viel Luft zuströmen kann, daß ein den Betrieb störender Unterdruck vermieden wird und auch nicht die Gefahr besteht, daß die im Raum zwischen Deckel und Badoberfläche befindlichen Gase oder Dämpfe nicht oder nur unzureichend in die Ansaugschlitze der Absaugung abgezogen werden. In diesem Fall sind die Merkmale des Anspruches 8 vorgesehen, die eine konstruktive Vereinfachung darstellen.

Die Ansprüche 9 bis 11 beinhalten Ausführungsmöglichkeiten, bei denen eine genügende Luftzufuhr von den Stirnseiten her gegeben ist. Diese Ausführungsmöglichkeiten können je für sich oder in Kombination miteinander eingesetzt werden.

Weitere Vorteile und Merkmale der Erfindung sind der nachfolgenden Beschreibung und der zugehörigen, im wesentlichen schematischen Zeichnung von Ausführungsmöglichkeiten der Erfindung zu entnehmen. In der Zeichnung zeigt:
- Fig. 1 und 3:: einen Querschnitt gemäß der Linie A-A in Fig. 4 beim Absenken und Anheben des Warenträgers mit Gut,
- Fig. 2:: einen Schnitt gemäß der Linie B-B in Fig. 5 bei abgesenktem und vom Deckel gelöstem Warenträger,
- Fig. 4 und 5:: Seitenansichten zu einer Vorrichtung gemäß den Figuren 1 bis 3,
- Fig. 6 und 7:: einen Ausschnitt aus einer Anlage mit einer Be- und Entladestation, einer Speicherstation und einer mehrzelligen Badstation.

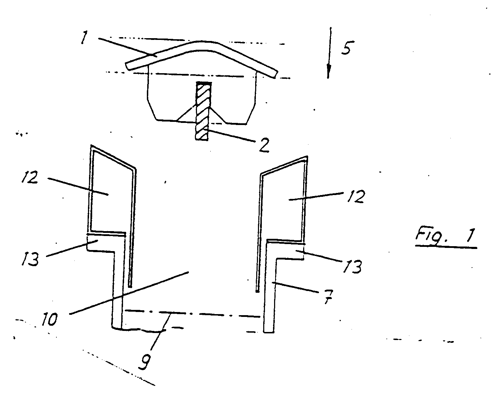

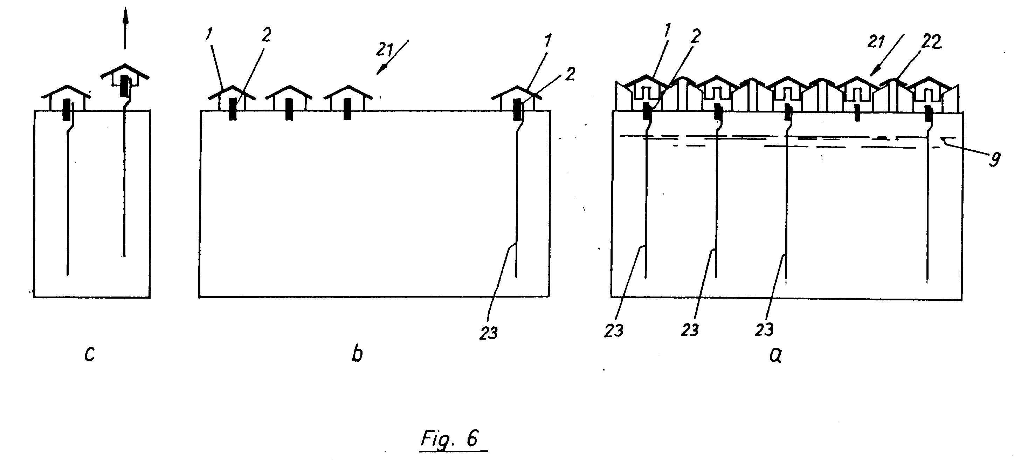

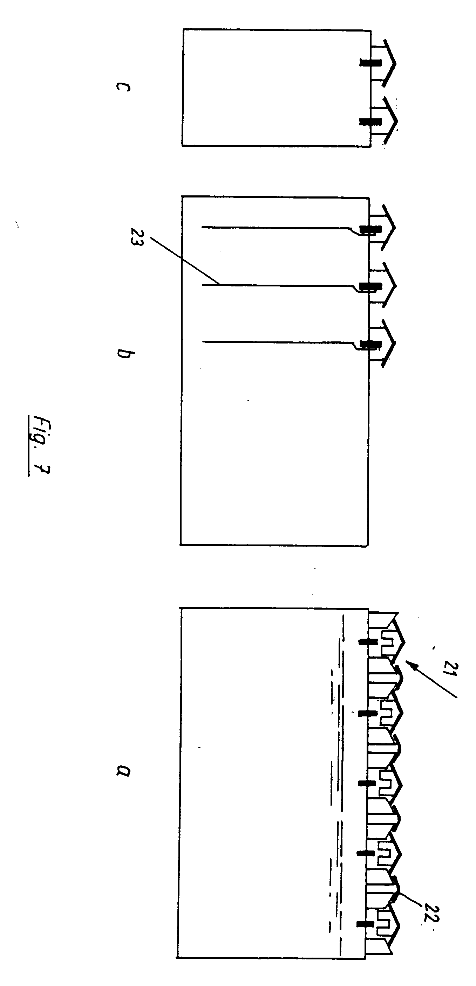

Die Figuren 1 bis 5 zeigen, daß der Deckel 1 und der schienenförmige Warenträger lösbar miteinander verbunden sind. Ausführungsmöglichkeiten dieser Verbindung werden weiter unten erläutert. Der Warenträger 2 besitzt seitlich Tragarme 3, unter die Hebearme 4 eines in der Zeichnung nicht dargestellten Transportwagens greifen können. Während des Absenkens (Pfeile 5) des Warenträgers mit den Haltevorrichtungen 23 (siehe Figuren 6 und 7) des angebrachten Gutes 6 in den Badbehälter 7 und auch während des Herausnehmens (Pfeile 8) des Gutes aus dem Badbehälter hängt das Gut über den Warenträger 2 und dessen Hebearme 3 an den Tragarmen 4 des Transportwagens.

Zum Absaugen der im Badbehälter oberhalb des Flüssigkeitsspiegels 9 im Raum 10 befindlichen Gase und Dämpfe sind stegförmige Absaugungen 12 vorgesehen. Sie können auf den Rändern 13 der Badbehälter 7 aufliegen und besitzen in den Raum 10 hineinragende Lufteintritts- und Ansaugöffnungen oder Ansaugschlitze 14. Im einzelnen wird hierzu auf die Erläuterungen in DE-A- 3908778 verwiesen. Die Lufteintrittsöffnungen 14 der Absaugungen 12 sind in einem entsprechenden Abstand unterhalb des oberen Randes des Badbehälters bzw. des oberen Randes der Einheit aus Badbehälter 7 und Absaugungen 12 vorgesehen. Sie befinden sich oberhalb der maximalen Badhöhe 9.

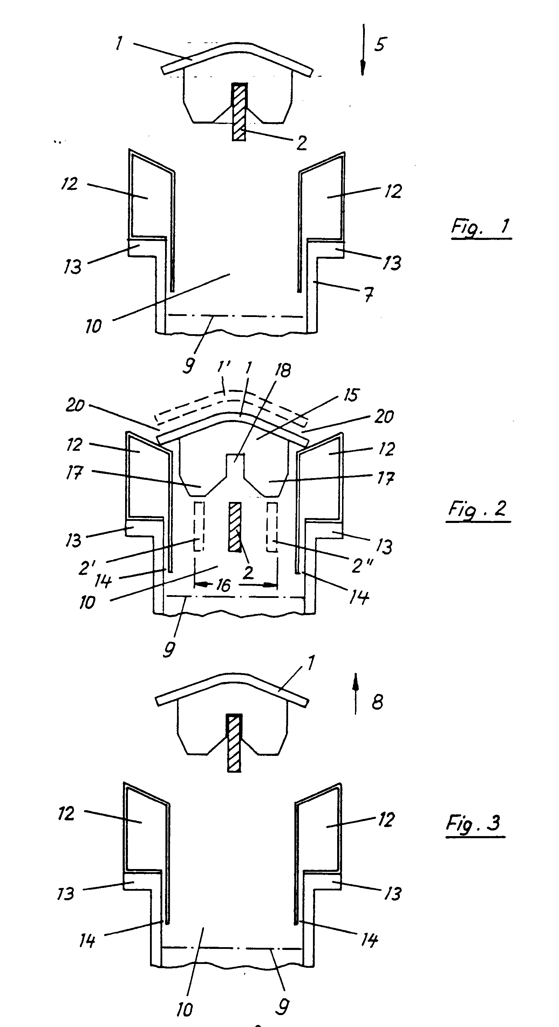

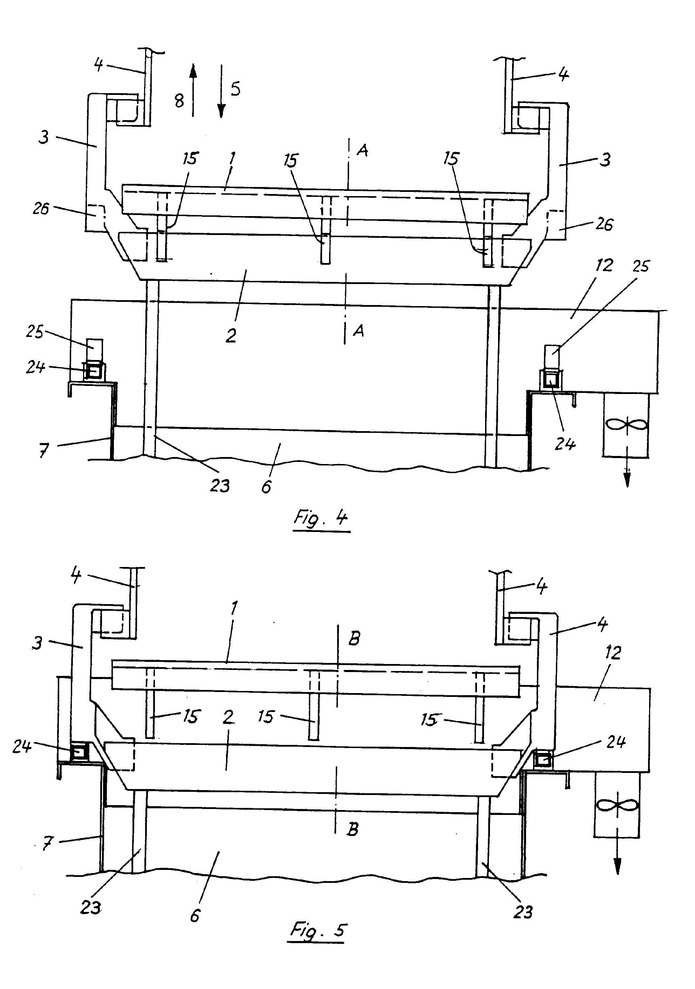

Das Aufbringen der Deckel 1 auf die Absaugungen 12 in der Abdecklage gemäß Figuren 2 und 5 wird durch die erläuterte Absenkung der Warenträger 2 mit Hilfe des sowieso vorhandenen Transportwagens erreicht. Das gleiche gilt, wie erläutert, für das Abheben. Fig. 1 zeigt in einem gewissen Abstand über den stegartigen Absaugungen 12 einen Warenträger 2, der oberseitig den Deckel 1 trägt. Der Absenkvorgang (siehe Pfeile 5) ist in Fig. 2 abgeschlossen. Fig. 2 zeigt ferner eine lösbare Verbindung zwischen Warenträger 2 und Deckel 1, um nach Auflage des Deckels auf den Absaugungen 12 die Abwärtsbewegung des Deckels zu unterbrechen und durch ein weiteres Absenken des Warenträgers ihn aus den Halterungen 15 des Deckels 1 zu lösen, bis der Warenträger in die Position gemäß Fig. 2 gelangt. Damit ist die Verbindung zwischen Deckel und Warenträger gelöst und der Warenträger in einer Position, in der durch ein Hin- und Herbewegen des Warenträgers 2 gemäß dem Doppelpfeil 16 in die Stellungen 2′ und 2˝ eine entsprechende Bewegung der Ware innerhalb der Badflüssigkeit vorgenommen werden kann. Dies kann (siehe Fig. 4) in der Weise geschehen, daß der Warenträger mit Ausnehmungen 26 in seiner abgesenkten Lage (gemäß Fig. 5) auf Einweisungen 25 aufsitzt, die an Stangen 24 befestigt sind. Diese Stangen werden in der Darstellung gemäß Fig. 5 senkrecht zur Zeichenebene bewegt, was die vorgenannte Hin- und Herbewegung des Warenträgers 2 gemäß dem Pfeil 16 zur Folge hat.

Die Halterungen 15 besitzen zwei Arme 17, zwischen denen sich ein Schlitz 18 zum Überstecken dieser Halterungen über den Warenträger 2 befindet. Dies ist nur eine Ausführungsmöglichkeit. Man könnte z.B. auch entlang der Unterseite des Deckels 1 eine durchgehende, schlitzförmige Öffnung vorsehen, welche über den schienenförmigen Warenträger paßt. Fig. 3 zeigt schließlich den Abhebevorgang gemäß Pfeil 8.

In der Absenklage gemäß Fig. 2 kann der Deckel 1 mit seinen Enden direkt auf den Absaugungen 12 (oder auf dem Badbehälter, falls dieser über die Absaugungen hinausragen sollte) aufliegen, sofern von den in Fig. 4 und 5 links und rechts gelegenen Stirnseiten der Badbehälter 7 her genügend Luft in den Raum 10 einströmen kann. Dies ist entweder dann gegeben, wenn der Abstand zwischen den vorgenannten Stirnseiten relativ kurz ist, so daß die von den Stirnseiten her einströmende Luft auch etwa bis zur Badbehältermitte gelangen kann, und/oder wenn an den Stirnseiten solcher Badbehälter Luftzutrittsöffnungen mit einem genügend freien Querschnitt für das Durchströmen von Luft vorhanden sind. Dies ist z.B. dann gegeben, wenn nicht allzuviel an Leitungen an diesen Stirnseiten in den Badbehälter hineinführen. Sollten Konsolen gemäß DE-A- 3908778 vorgesehen sein, so empfiehlt es sich - im Gegensatz zum Ausführungsbeispiel von DE-A- 3908778 - diese als aus Flachstahl gebogene Bügel auszubilden, die mittels Laschen am Badbehälterrand 13 befestigt sind. Auf diesen Bügeln können, wenn notwendig, Einweisungen, z.B. zum Positionieren des Deckels in seiner Längsrichtung, aufgebracht und befestigt werden.

Bei breiteren Bädern dagegen, oder wenn aus einem anderen Grund der Luftzutritt allein von den Stirnseiten her in den Raum 10 nicht genügend ist, empfiehlt sich die Halterung des Deckels in einem gewissen Abstand von den Absaugungen oder dem Badbehälter, wie es in Fig. 2 gestrichelt mit Ziffer 1′ dargestellt ist. In diesem Fall wird der Deckel 1′ in seiner gestrichelt gezeichneten Position durch nicht gesondert dargestellte Einweisungen (siehe auch hierzu P 39 08 778.6) so gehalten, daß zwischen seinen Enden und der Oberseite der Absaugungen oder des Badbehälters eine Luftdurchtrittsöffnung 20 besteht.

Ist der Behandlungsvorgang des Gutes beendet und soll der Warenträger mit Hilfe des Transportwagens wieder aus diesem Behandlungsbehälter abgeholt werden, wird zunächst die Gutbewegung gemäß dem Doppelpfeil 16 so stillgesetzt, daß der Warenträger 2 sich in der Mittelposition direkt unter dem Schlitz bzw. den Schlitzen 18 des Deckels 1 befindet. Wird nun der Warenträger 2 angehoben, gleitet der Deckel 1 auf die Warenträgerschiene auf und wird mitgenommen.

Hat der Warenträger 2 mit seinen Haltevorrichtungen 23 und dem daran hängenden Gut das betreffende Bad verlassen, so ist zwar während dieses Zeitraumes die Oberseite des Bades nicht abgedeckt, doch wird in der Regel bei mehrzelligen Aktivbädern, wie sie z.B. Galvanisierbäder darstellen, unmittelbar danach ein neuer Warenträger eingefahren, um die Kapazität der Anlage voll zu nutzen.

Fig. 6 und 7 zeigen bei Betrieb der Anlage (Fig. 6) und bei Betriebspausen (Fig. 7) die Anordnung von Warenträgern 2 mit Deckel 1 und Haltevorrichtungen 23 für das Gut 6 einerseits und sogenannten Leerträgern 21 andererseits, die lediglich aus einem Warenträger 2 (aber ohne Haltevorrichtungen) und dem zugehörigen Deckel 1 bestehen.

Der Badbehälter der mehrzelligen Badstation a in Fig. 6 und 7 ist mit einer Badflüssigkeit versehen, wie es durch den Badspiegel 9 angedeutet ist. b bezeichnet in Fig. 6 und 7 eine Speicherstation, deren Abteilungen kein Bad aufweisen. Mit c ist jeweils die übliche Be- und Entladestation für das Anbringen oder Abnehmen des Gutes 6 an die bzw. von den Tragvorrichtungen 23 bezeichnet. Der Badbehälter der Badstation a besteht aus einer Reihe von Zellen, die ohne Trennwände ineinander übergehen und mit derselben Badflüssigkeit gefüllt sind. Sollte in einer der Zellen kein Gut behandelt werden, so wird sie durch einen der erläuterten Leerträger 21 abgedeckt. Die Leerträger 21 kommen also dann auf die Oberseiten der Zellen der Badstation a, sobald die Warenträger mit Tragvorrichtungen aus der betreffenden Zelle herausgenommen und in der Speicherstation b abgelegt wurden. Da die Leerträger keine Tragvorrichtungen aufweisen, können sie über beliebig lange Zeit sich oberhalb der Behandlungsbäder, bzw. Zellen befinden. Die Leerträger sind gegenüber den Warenträgern insofern einfacher aufgebaut und ausgebildet, da sie nur die Aufgabe des Tragens des Deckels haben, nicht aber die des Tragens des Gutes. Wird die Anlage wieder angefahren, so werden die betreffenden Leerträger aus der Badstation a herausgenommen und die Warenträger mit dem zu behandelnden Gut eingebracht. Wie bereits erwähnt, sind Abdeckungen mit Hilfe des Deckels 1 nur an solchen Zellen oder Badbehältern nötig, an denen schädliche Gase oder Dämpfe entstehen und abgesaugt werden müssen, und die hierzu sämtlich mit den Absaugungen versehen sind. Sofern zwischen den Absaugungen nebeneinander liegender Zellen ein Zwischenraum besteht (siehe Fig. 6a und 7a), sind diese mit einer festen Abdeckung 22 überdeckt, womit dort der Austritt von Gasen oder Dämpfen verhindert wird. Leerträger 21, die zeitweise nicht benötigt werden, sind an der Oberseite der Speicherstation b abgelegt. Dies gilt auch für Warenträger 2 mit Deckel 1, deren Tragvorrichtungen 23 kein Gut aufweisen und erst bei Bedarf mittels des Transportwagens zur Beladestation c gebracht und dort beladen werden. Während einer Betriebspause (Fig. 7) sind die einzelnen Zellen der Badstation a durch Leerträger 21 abgedeckt. Die Warenträger mit Tragvorrichtungen 23 sind im Speicher b abgelegt, so daß sie nicht durch längeres Hängen in einer Badflüssigkeit angegriffen werden.

Zusammengefaßt ergibt die Erfindung eine vorteilhafte Abdeckung von mit Badflüssigkeit versehenen Badbehältern oder Zellen, als auch die Beibehaltung der erläuterten vorteilhaften Absaugung gemäß dem Stand der Technik, sowie die Hin- und Herbewegung der Warenträger während der Behandlungsphase.

## Patentansprüche

1. Vorrichtung zum Galvanisieren von Behandlungsgut, z.B. von elektronischen Leiterplatten, mit einer Anzahl in Reihe hintereinander angeordneten, an ihrer Oberseite offenen Badbehältern, mit Deckeln zum wahlweisen Abdecken dieser Oberseiten, mit einer Absaugung mit Lufteintritts- und Ansaugöffnungen oder Ansaugschlitzen von Luft und von den in den Badbehältern oberhalb des Flüssigkeitsspiegels der Badflüssigkeit befindlichen Gasen oder Dämpfen und mit einem Transportwagen zum Ein- und Ausbringen des von Warenträgern gehaltenen Behandlungsgutes in die oder aus den Bädern, wobei sich die Lufteintritts- und Ansaugöffnungen oder Ansaugschlitze der Absaugung in einem solchen Abstand unterhalb des oberen Randes des Badbehälters oder des oberen Randes einer Einheit aus Badbehälter und Absaugungen befinden, daß Wirbelungen der eingesaugten Luft weitgehend vermieden sind und ein wesentlicher Teil der Gase und Flüssigkeitsdämpfe im Raum oberhalb des Flüssigkeitsspiegels des Bades vom eingesaugten Luftstrom erfaßt wird, wobei jedoch die Lufteintritts- und Ansaugöffnungen oder Ansaugschlitze sich oberhalb der maximalen Badhöhe befinden, dadurch gekennzeichnet, daß die Deckel (1) jeweils von einem unterhalb des Deckels befindlichen Warenträger (2) getragen sind und von dem Warenträger in die Schließlage absenkbar, sowie aus dieser abhebbar sind, und daß der jeweilige Warenträger von dem zugehörigen Deckel lösbar und der gelöste Warenträger weiter nach unten in eine Position absenkbar ist, in der er zusammen mit dem an ihm hängenden und im Bad befindlichen Gut in horizontaler Richtung hin- und herbewegt werden kann.

2. Vorrichtung nach Anspruch 1, dadurch gekennzeichnet, daß die Warenträger quer zur Ebene eines im Bad hängenden Gutes hin- und herbewegbar sind.

3. Vorrichtung nach Anspruch 1 oder 2, dadurch gekennzeichnet, daß an der Deckelunterseite Halterungen oder Aufnahmeöffnungen (15,18) für den Warenträger (2) vorgesehen sind.

4. Vorrichtung nach Anspruch 3, dadurch gekennzeichnet, daß an der Unterseite des Deckels ein entweder durchgehender Schlitz oder mehrere in Flucht hintereinander vorgesehener Schlitze vorgesehen sind, die jeweils über den schienenförmigen Warenträger (2) steckbar sind.

5. Vorrichtung nach Anspruch 4, dadurch gekennzeichnet, daß an der Deckelunterseite über die Längsrichtung des Deckels verteilt im Abstand voneinander mehrere Haltestege (17) mit Schlitz (18) für das Aufstecken auf den Warenträger vorgesehen sind.

6. Vorrichtung nach einem der Ansprüche 1 bis 5, dadurch gekennzeichnet, daß Leerträger (21) in Form von den Warenträgern (2) entsprechenden Schienen und zugehörigen Deckeln (1) vorgesehen sind.

7. Vorrichtung nach einem der Ansprüche 1 bis 6, dadurch gekennzeichnet, daß die Höhenlage und Dimensionierung der Deckel (1) zum Badbehälter (7) oder den Absaugungen (12) so gewählt ist, daß zwischen Deckel und Badbehälter oder Absaugungen beidseitig ein Luftdurchtritt (20) besteht.

8. Vorrichtung nach einem der Ansprüche 1 bis 6, dadurch gekennzeichnet, daß die Deckel (1) in der Abdecklage mit ihren Rändern auf den Absaugungen (12) oder dem Badbehälter oder der Zelle aufliegen.

9. Vorrichtung nach Anspruch 8, gekennzeichnet durch im wesentlichen offene Luftzutrittsöffnungen an den Stirnseiten der Badbehälter.

10. Vorrichtung nach Anspruch 8 oder 9, wobei in der Abdecklage die Deckel auf Einweisungen aufsitzen, die von zwischen den Absaugungen befindlichen Haltern gehalten sind, dadurch gekennzeichnet, daß die Halter so gestaltet sind, daß der freie Querschnitt der Luftzutrittsöffnungen an den Stirnseiten möglichst wenig verkleinert wird.

11. Vorrichtung nach einem der Ansprüche 8 bis 10, gekennzeichnet durch relativ schmale Badbehälter mit einem relativ geringen Abstand zwischen den beiden Stirnseiten.

## Claims

1. Apparatus for electroplating articles to be treated, e.g. electronic printed circuit boards, having a number of bath containers, which are disposed in series behind one another and are open at their upper ends, covers for selectively covering these upper ends, a suction means provided with air inlet apertures and suction apertures or suction slots for the suction of air and gases or vapours situated in the bath containers above the fluid level of the bath fluid, and a carriage for introducing the articles to be treated, which are retained by article carriers, into the baths and removing such therefrom, the air inlet apertures and suction apertures or suction slots in the suction means being situated at such a spacing beneath the upper edge of the bath container or beneath the upper edge of a unit comprising bath container and suction means that turbulence phenomena of the drawn-in air are largely avoided and a substantial portion of the gases and liquid vapours is collected in the space above the fluid level of the bath by the drawn-in stream of air, but the air inlet apertures and suction apertures or suction slots being situated above the maximum bath height, characterised in that the covers (1) are each supported by a respective article carrier (2) situated beneath the cover and are lowerable by the article carrier into the closed position, as well as being raisable therefrom, and in that the respective article carrier is releasable from the associated cover, and the released article carrier is lowerable further downwardly into a position in which it can be reciprocated in a horizontal direction together with the article which is suspended thereon and situated in the bath.

2. Apparatus according to claim 1, characterised in that the article carriers are reciprocatable transversely relative to the plane of an article suspended in the bath.

3. Apparatus according to claim 1 or 2, characterised in that retaining means or receiver apertures (15, 18) are provided for the article carrier (2) on the underside of the cover.

4. Apparatus according to claim 3, characterised in that either a continuous slot or a plurality of slots, which are provided in alignment behind one another, are provided in the underside of the cover and can each be placed over the respective rail-like article carrier (2).

5. Apparatus according to claim 4, characterised in that a plurality of retaining arms (17) are distributed on the underside of the cover over the longitudinal direction of the cover with a spacing therebetween and have a slot (18) for mounting on the article carrier.

6. Apparatus according to one of claims 1 to 5, characterised in that empty carriers (21) are provided in the form of rails, corresponding to the article carriers (2), and associated covers (1).

7. Apparatus according to one of claims 1 to 6, characterised in that the vertical position and dimensioning of the covers (1) relative to the bath container (7) or the suction means (12) are so selected that there is an air passage (20) on each side between the cover and bath container or suction means.

8. Apparatus according to one of claims 1 to 6, characterised in that the covers (1) in the covered position lie with their edges on the suction means (12) or on the bath container or cell.

9. Apparatus according to claim 8, characterised by substantially open air inlet apertures in the end faces of the bath containers.

10. Apparatus according to claim 8 or 9, the covers in the covered position resting on guide means which are retained by holders situated between the suction means, characterised in that the holders are so configured that the free cross-section of the air inlet apertures in the end faces is reduced as little as possible.

11. Apparatus according to one of claims 8 to 10, characterised by relatively narrow bath containers having a relatively small spacing between the two end faces.

## Revendications

1. Dispositif pour la galvanisation d'éléments à traiter, par exemple, de cartes imprimées, comportant un nombre de cuves disposées en ligne les unes derrière les autres, ouvertes sur leur côté supérieur, comportant des couvercles permettant de couvrir au choix ces côtés supérieurs, avec un système d'extraction comportant des ouvertures d'admission et d'extraction d'air ou des fentes d'extraction de l'air et des gaz ou vapeurs situés dans les cuves, au-dessus de la surface libre du liquide constituant le bain, et avec un wagonnet de transport destiné à faire entrer dans ou sortir hors des bains des éléments à traiter, supportés par des supports d'éléments, les ouvertures d'admission et d'extraction d'air ou les fentes d'extraction du système d'extraction se situant à une distance telle, en-dessous du bord supérieur de la cuve ou du bord supérieur d'une unité constituée de cuves et de systèmes d'extraction, que des tourbillons de l'air admis sont évités en large mesure et qu'une partie essentielle des gaz et des vapeurs de liquides, situés dans l'espace situé au-dessus de la surface du liquide du bain, est captée par le flux d'air admis, les ouvertures d'admission et d'extraction ou les fentes d'extraction d'air se situent au-dessus du niveau maximal de bain, caractérisé en ce que les couvercles (1) sont chacun portés par un support (2) d'éléments situé en-dessous du couvercle, peuvent être baissés par le support d'éléments en position de fermeture et peuvent être soulevés, à partir de ladite position, et en ce que le support d'éléments peut, une fois désolidarisé, être abaissé dans une position dans laquelle il peut, avec la pièce suspendue et plongée dans le bain, être déplacé horizontalement selon un mouvement de va et vient.

2. Dispositif selon la revendication 1, caractérisé en ce que les supports d'éléments sont mobiles selon un mouvement de va et vient, transversalement par rapport au plan d'une pièce suspendue dans un bain.

3. Dispositif selon l'une quelconque des revendications 1 ou 2, caractérisé en ce que des fixations ou des ouvertures (15, 18) formant logements pour le support d'éléments (2) sont prévues sur le côté inférieur du couvercle.

4. Dispositif selon la revendication 3, caractérisé en ce que sur le côté inférieur du couvercle il est prévu soit une fente continue soit plusieurs fentes alignées les unes avec les autres, dans lesquelles peut venir s'encliqueter le support d'éléments (2) ayant la forme d'un rail.

5. Dispositif selon la revendication 4, caractérisé en ce que sur le côté inférieur du couvercle il est prévu plusieurs ailes de fixation (17) comportant une fente (18) pour l'encliquetage sur le support d'éléments, qui sont réparties dans le sens longitudinal du couvercle, à distance les unes des autres.

6. Dispositif selon l'une quelconque des revendications 1 à 5, caractérisé en ce qu'il est prévu des supports vides (21) de la forme des rails correspondant aux supports d'éléments (2) et des couvercles correspondants.

7. Dispositif selon l'une quelconque des revendications 1 à 6, caractérisé en ce que la position en hauteur et le surdimensionnement des couvercles (1) par rapport à la cuve (7) ou aux systèmes d'extraction sont choisis de manière telle, qu'un passage d'air est créé de part et d'autre, entre le couvercle et les cuves ou les systèmes d'extraction.

8. Dispositif selon l'une quelconque des revendications 1 à 6, caractérisé par les couvercles (1) en position de recouvrement, reposent, par leurs bords, sur les systèmes d'extraction (12) ou sur la cuve ou la cellule.

9. Dispositif selon la revendication 8, caractérisé par des ouvertures d'admission d'air sensiblement ouvertes, situées sur les faces frontales des cuves.

10. Dispositif selon l'une quelconque des revendications 8 ou 9, caractérisé en ce que dans la position de recouvrement, les couvercles reposent au-dessus d'installations qui sont maintenues par des fixations situées entre les systèmes d'extraction, caractérisé en ce que les fixations sont conçues de manière à ce que la section libre des ouvertures d'admission d'air soit aussi peu réduite que possible, sur les faces frontales.

11. Dispositif selon l'une quelconque des revendications 8 à 10, caractérisé par des cuves relativement étroites présentant un écartement relativement réduit entre les deux faces frontales.
